# EUROPEAN PATENT SPECIFICATION

(11) **EP 4 121 780 B1**
(45) Date of publication and mention of the grant of the patent: **30.09.2026**
(21) Application number: 21718509.9
(22) Date of filing: 22.03.2021
(51) Int. Cl.: G01P 15/08, H03K 17/945, B65G 1/02

(54) **SENSOR APPARATUS**
SENSORVORRICHTUNG
APPAREIL CAPTEUR

(30) Priority: 20.03.2020 GB 202004112
(43) Date of publication of application: 25.01.2023
(73) Proprietor: Raxpro Limited, Woodnesborough, Kent CT13 0NY (GB)
(72) Inventor: HYETT, Peter, Woodnesborough Kent CT13 0NY (GB)
(74) Representative: Bridle, Andrew Barry
(86) International application number: PCT/EP2021/057245
(87) International publication number: WO 2021/186077

(56) References cited:
- WO-A1-2017/203235
- CN-U- 209 080 712
- KR-A- 20130 045 877
- US-A1- 2008 073 431
- US-A1- 2010 167 783
- US-A1- 2014 361 883

## Description

The present invention relates to a sensor apparatus and in particular to an apparatus that can be secured to a storage rack to detect, prevent or reduce collisions between the storage rack and mobile bodies, such as motorised trucks and/or to detect such contacts.

Storage racking systems, such as pallet racks, are commonly used in most warehouses and other storage areas in order to maximise the available storage space.

A pallet rack is typically a system of vertical, diagonal and horizontal interconnecting steel components. Pallet rack installations are usually arranged with a one pallet deep run of racking on either side of an access aisle. Known racking consists of two major components, upright frames and beams. Upright frames are assembled using pairs of continuously perforated uprights connected by bracing components with bolted, riveted or welded joints. Examples of such pallet racking systems are disclosed in WO2005/103389.

Storage racking is typically arranged to maximize the usage of available storage space, which means the dimension between adjacent runs of storage racking is arranged at a minimum but commensurate with providing sufficient space to enable the use of mechanical handling equipment (MHE), such as a powered industrial truck, to manoeuvre pallets and or unit loads into and out of the storage bays defined by the racking. Because of the onus to minimise the distance across the access aisle, the MHE must manoeuvre within close proximity of the storage rack components. Whilst carrying out manoeuvring to place or remove a pallet or unit load on or from the storage racking there is a likelihood that unintended contact will occur between the MHE or the pallet/unit load it is carrying with one or more components of the storage racking system.

Often this unintended contact may be due to an operator of the MHE misjudging the position of the equipment and/or the load being manoeuvred with the location of the static components of the storage racking into which the load is being placed or from which it is being removed.

The structural components of the racking system are generally not designed to resist significant impact or force due to such unintended contact.

Often the forces exerted on contact are sufficient to cause deflection of the structural rack or shelf members. The momentum of an MHE, e.g. a 2 tonne powered industrial truck coupled with the mass of the carried load, is significant. Damage due to impact by the MHE and/or its load on the structural components of a shelf or pallet racking system may lead to failure of the member and collapse of the storage racking resulting in injury and possible death of those in the vicinity of the failed component(s).

Minor damage to racking uprights can be tolerated providing the damage is within specific tolerances. Guidelines and standards exist for the acceptable deflection due to minor impact of structural members. Should the deflection exceed the standard or guideline replacement and/or repair is required. The Storage Equipment Manufacturer's Association (S.E.M.A) Code of Practice (and the corresponding national code of practice in other states) is considered within the storage industry as the minimum standard with which to measure the safe condition of racking.

There are several known devices on the market that claim to protect pallet or shelf racking uprights by spreading the impact force that results should the MHE come into contact with the known device and racking component.

US 2014/361883 A1, KR 2013 0045877 A, WO 2017/203235 A1, US 2010/167783 A1 and CN 209 080 712 U describe proximity or collision sensors, some of which are connected to storage racks. In particular, KR 2013 0045877 A teaches a three-part coupling system comprising an inner shock absorbing member, an outer C-shaped fixing body comprising a clip portion and an inner fixing panel comprising a resiliently deformable structure wherein the clip portion when inserted into the fixing panel provides an elastic force to the deformable structure for coupling a rack post.

However, the purpose of the present invention is to record impacts and optionally also to avoid or minimise contact with storage racking components by providing an alert signal, for example an audible and/or visual alert signal, if the proximity of the powered industrial truck and/or its load gets within a pre-determined distance from the storage racking or components thereof, to allow the operator to take action to avoid any impact, or to detect such impacts in order for any remedial action to be taken promptly.

According to a first aspect of the invention, there is provided a sensor apparatus for connection to a storage rack, the sensor comprising a body which defines a housing; a power source located within the housing; one or more impact and/or proximity sensors located within the housing and electrically connected to the power source; a processor located within the housing and electrically connected to the power source and the or each sensor; and a signal emitter located within the housing and electrically connected to the power source and the processor, wherein the signal emitter emits a signal in response to an activation signal from the processor. The activation signal may be in response to an object being located in proximity to the sensor apparatus and/or in response to an impact sensed by the or one of the impact sensors.

Thus, in a first embodiment of the invention, there is provided a sensor apparatus for connection to a storage rack, the sensor apparatus comprising a body which defines one or more housings; a power source located within the housing or one of the housings; one or more impact sensors carried by the body and electrically connected to the power source; a processor located within the housing or one of the housings and electrically connected to the power source and the or each impact sensor; and a signal emitter carried by the body and electrically connected to the power source and the processor, wherein the signal emitter emits an signal in response to an impact sensed by the or each impact sensor.

The impact sensor apparatus may be secured to a component of the storage racking assembly or located adjacent thereto and is capable of emitting a signal if the apparatus is struck.

The or each impact sensor is suitably capable of sensing the force of the impact. For example, the or each sensor may include a force transducer which emits an electrical signal when the force of the impact exceeds a threshold value. Additionally or alternatively, the emitted signal may correspond to the magnitude of the force of the impact.

The signal emitted by the signal emitter may include data relating to the force of the impact, for example, whether the impact was above or below a threshold value. The signal may be transmitted to a memory storage component carried by the sensor apparatus and/or it may be transmitted to a remote signal receiver, which logs the data relating to the impact. A user may determine, based on the transmitted data, if remedial action or a repair of the racking is required.

In an embodiment of the invention, the impact sensor apparatus further includes one or more proximity sensors carried by the body and electrically connected to the power source and to the processor, wherein the signal emitter further emits an alert signal in response to the or each proximity sensor sensing an object within a predetermined distance of the respective sensor.

According to a further embodiment of the invention, there is provided a sensor apparatus for connection to a storage rack, the sensor apparatus comprising a body which defines one or more housings; a power source located within the housing or one of the housings; one or more impact and/or proximity sensors carried by the body and electrically connected to the power source; a processor located within the housing or one of the housings and electrically connected to the power source and the or each proximity sensor; and a signal emitter carried by the body and electrically connected to the power source and the processor, wherein the signal emitter emits an alert signal in response to an activation signal from the processor.

Thus, the sensor apparatus of the invention may sense when the distance between a mobile object (such as MHE) and the proximity sensor apparatus becomes less that a pre-determined distance and/or if the apparatus detects a contact with the apparatus. If the spacing is below a threshold spacing or distance, or the sensor detects contact with the apparatus, the processor transmits an activation signal to the signal emitter which in turn may emit an alert signal and/or a data signal including data relating to the force of the impact.

For example, the threshold spacing or distance at which the signal emitter emits an alert signal may be from 0cm to 100cm.

There may be a single threshold spacing or distance and a single corresponding alert signal emitted by the signal emitter. Alternatively, there may be a plurality of threshold values for the spacing or distance of an object from the proximity sensor and each threshold value may have associated with it a corresponding alert signal. For example, where the alert signal includes an audible signal, the volume and/or frequency of the audible signal may increase, the closer the object gets to the proximity sensor. Additionally or alternatively where the alert signal includes a visual alert signal, the alert signal may be a constant signal between a first and second pre-determined value and then the visual signal may flash with increasing frequency as the object approaches the proximity sensor.

The skilled person will appreciate that the signal emitter may emit a combination of audible and visual alert signals.

In addition to or as an alternative to visual and/or audible alert signals, the signal emitter may emit an electronic alert signal, such as a wireless alert signal. The electronic alert signal may be received by a receiver carried by the MHE or the operator of the MHE. The receiver may transmit an activation signal to a remote alert emitter carried by the MHE or the operator of the MHE, such that a visual, audible and/or tactile alert may be transmitted to the operator or the MHE may be automatically slowed or stopped as a result of the remote activation signal before or after an impact occurs. For example, the electronic alert signal may be received by a receiver carried by a mechanical handling apparatus, wherein the receiver is connected to a controller and a stop signal is transmitted by the controller in response to the received alert signal. The stop signal may cause an interruption in the electrical power supplied to a motor in embodiments in which the MHE includes an electric motor and/or it may cause brakes to be applied on the MHE to prevent further movement of the MHE and possible impact with the storage racking. Thus, the stop signal may be transmitted by the controller to a switch located between an electrical power source and an electric motor and/or the stop signal may be transmitted to a brake actuator which is capable of applying a braking force to the MHE.

In an embodiment of the invention, the body defines one housing and the power source and the processor are located within the housing.

The signal emitter may include one or more audible alert signal emitters and/or one or more visual alert signal emitters.

The signal emitter may be located within the housing or one of the housings (e.g. when the alert signal is an audible signal or a wireless electronic signal) and apertures may be formed in the body that permit an audible alert signal to be transmitted externally of the housing. Alternatively, one or more visual and/or audible alert signal emitter may be carried externally on the housing.

The proximity sensor(s) and/or impact sensors are suitably mounted within the body or secured to the body. For example, when the proximity sensor(s) comprises ultrasonic sensor(s) or similar technology, at least a portion of the sensor may be flush with or extends beyond an outwardly facing surface of the body. Thus, the sensor(s) may be at least partially embedded within the body. In alternative embodiments, the or each sensor may comprise a capacitive sensor and/or a force-sensitive resistor, such sensor(s) may be secured to a surface of the body, such as an outwardly facing surface or an inwardly facing surface. In the context of the invention, an outwardly facing surface of the body faces away from the storage racking component and an inwardly facing surface faces towards the storage racking component.

The power source located within the housing or one of the housings may comprise one or more batteries, which in turn may be rechargeable. The use of batteries allows the sensor apparatus to be located for use without the need to provide power cables at the location site. Thus it can be used in conjunction with existing storage racking arrangements without the need for any modification to the storage racking. It also allows the sensor apparatus to be readily moved from one location to a different location.

For training and event recording purposes, the processor may include a data memory component which is configured to record data from the or each sensor. In this way, if a sensor apparatus located in a specific location records numerous contacts and/or "near misses", then this data may be used for training purposes, as it identifies an area which is at high risk of collisions. Additionally, the data may be used record collision and/or "near miss" data for reporting purposes.

The sensor apparatus is configured to be secured to a component of the storage racking. In order to achieve this, the apparatus includes one or more attachment elements for securing the body to the storage racking. Such securing elements may include separate components, such as straps or the like; elements which are integral with the apparatus; or combinations thereof.

The body includes or defines the or each attachment element. The body includes one or more resiliently deformable anchor elements extending from a main body portion of the body. The or each resiliently deformable anchor element may engage with a component of the storage racking to prevent or resist the detachment of the body from the component of the storage racking.

As MHE may approach the storage racking from a plurality of directions, the body of the sensor apparatus has an arcuate cross-section. In other words, the body is curved. This allows it to at least partially envelope a portion of a storage racking component, for example a vertically arranged storage racking component. The curved nature of the body allows the sensor(s) to sense the proximity of an object to the storage racking through an arc around the respective component and/or a contact force from a range of directions. This allows the apparatus to sense the approach of an object or an impact from any direction within the arc.

In an embodiment of the invention, the arc defined by the body may extend through an angle of from 60° to 270°.

Although the apparatus of the invention may be used to prevent and/or record impacts, the body of the apparatus may be formed from a polymeric material and may be resiliently deformable. In this embodiment, the body is able to absorb the energy of a relatively minor impact without transmitting a significant amount of the impact force to the respective component of the storage racking. Thus, the apparatus may also function as an impact absorber for the storage racking. Additionally or alternatively, the sensor apparatus may include an impact-absorbent outer layer and/or inner layer. This may, for example, comprise a foamed material which is able to absorb impacts via the deformation of the cells of the foamed material.

As many facilities that include storage racking are subject to stringent fire safety requirements, the body of the sensor apparatus may include a fire-resistant and/or a fire retardant material. Such a material may be included with the polymer blend if the body is formed from a polymeric material. Additionally or alternatively, the body may include a fire-resistant/fire retardant coating.

The sensor(s) may be any known type of proximity or impact sensor. For example, the proximity sensor(s) may utilise ultrasonic waves to sense the proximity of an object. Thus, the sensor(s) may be ultrasonic sensors. Such sensors are well known in the art. Alternatively, the or each sensor may be a capacitive sensor. Again, such sensors are well known in the art.

Alternatively, the sensor may be a capacitive proximity sensor (again, well known in the art) or a force-sensitive resistor.

The sensor apparatus may include two or more sensors. In such embodiments, the sensors may be the same or different.

According to a second aspect of the invention, there is provided a storage racking assembly including at least one upright component and a sensor apparatus secured to the upright component, wherein the sensor apparatus is as defined anywhere hereinabove in connection with the first aspect of the invention. Thus, the sensor apparatus used in connection with the second aspect of the invention may include any one or more of the optional features described herein in connection with the first aspect of the invention.

The body of the sensor apparatus includes one or more resiliently deformable anchor elements in the form of arms which extend from a main body portion of the body and the resiliently deformable arms snap-fit around the upright component which secures the apparatus to the upright component.

The skilled person will appreciate that the features described and defined in connection with the aspects of the invention and the embodiments thereof may be combined in any combination, regardless of whether the specific combination is expressly mentioned herein. Thus, combinations of optional features described and discussed herein are within the scope of the invention. The invention is defined by the appended claims.

An embodiment of the invention will now be described, by way of example only, with reference to the accompanying drawings in which:
Figure 1 is a perspective view of a sensor apparatus according to the first aspect of the invention, showing schematically a housing defined within a body of the apparatus;
Figure 2 is a rear elevational view of the sensor apparatus shown in Figure 1;
Figure 3 is a perspective view of the sensor apparatus shown in Figure 1 connected to an upright member of a storage rack; and
Figure 4 is a perspective view of a storage racking assembly according to the second aspect of the invention.

For the avoidance of doubt, the skilled person will appreciate that in this specification, the terms "up", "down", "front", "rear", "upper", "lower", "width", "above", "below", etc. refer to the orientation of the components of the invention when installed for normal use as shown in the Figures.

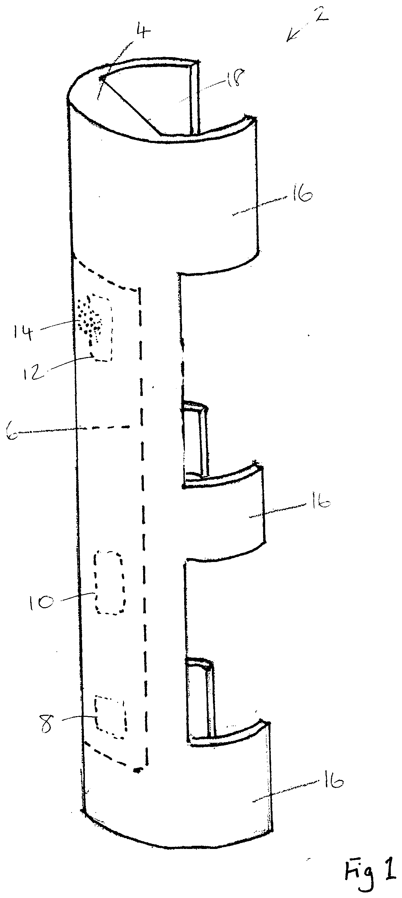

Figure 1 shows a proximity sensing apparatus 2 according to the first aspect of the invention.

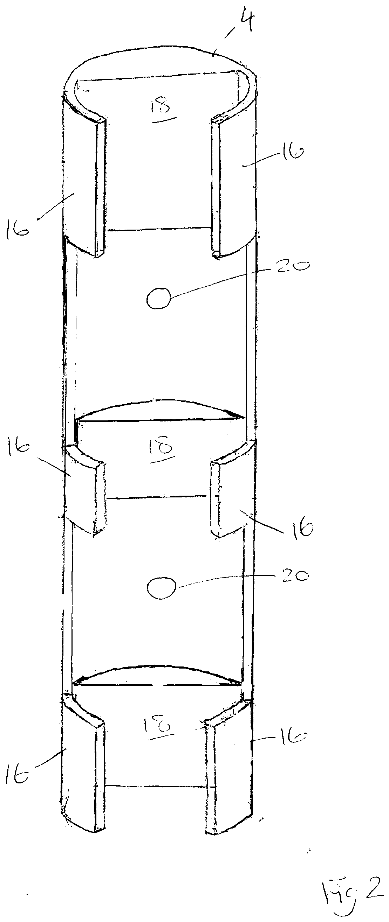

The proximity sensing apparatus 2 comprises a curved body 4 formed from a polymeric material. Defined within the body 4 and shown schematically in Figure 1 is a housing 6. Within the housing 6 is located an electrical power source 8. The electrical power source is connected to and powers a processor 10. The processor 10 is electrically connected to a pair of sensors 20 (shown in Figure 2) and an alert emitter 12. In the subject embodiment, the alert emitter 12 is an audible sound emitter which emits an audible alarm in response to a signal received from the processor 10. In order to allow the audible alarm to be heard, an array of through holes 14 are formed through the wall portion adjacent to the alert emitter 12. The alert emitter is electrically connected to and powered by the power source 8.

Although an audible alarm is described as the alert emitter 12 in this embodiment, the skilled person will appreciate that the alert emitter 12 may additionally or alternatively include other forms of alert emitter, such as a visual alert emitter in the form of a light source which may flash and/or an electronic wireless signal which may be transmitted to a remote receiver.

Extending rearwardly from the main body portion are six resiliently deformable anchor elements in the form of arms 16. The arms 16 may be deflected outwards by an external force. After the external force has been removed, the arms 16 will snap back to their rest configuration.

Figure 2 shows a rear elevational view of the body 4. As can be seen more clearly in Figure 2, spacing elements 18 having a planar contact surface are provided on the rear of the main body portion. These spacing elements 18 ensure that sensors 20 located between the spacing elements are spaced from components of a storage racking assembly to which the proximity sensing apparatus 2 is coupled in use, thereby minimising the risk of damage to the sensors. In addition, the planar contact surface of the spacing elements permits the correct orientation of the proximity sensing apparatus 2 relative to the storage racking assembly.

The sensors 20 in this embodiment are capacitive sensors, such as the type sold by Texas Instruments under the reference number FDC1004. However, it will be appreciated that alternative proximity sensors, such as ultrasonic sensors may be used in the context of the subject invention.

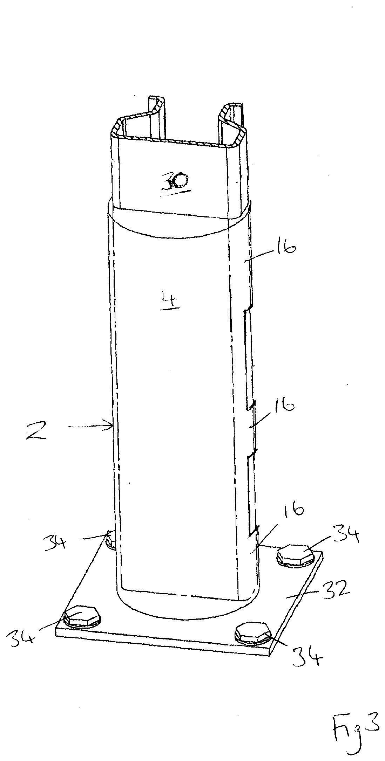

Figure 3 shows the proximity sensing apparatus 2 coupled to an upright component 30 of a storage racking assembly. The upright component 30 is secured to a floor via a base plate 32 and a plurality of bolts 34 which pass though the base plate 32 and into the floor. In order to secure the proximity sensing apparatus 2 to the upright component 30, the arms 16 are urged apart until they define a gap between opposed arms which is greater than the width of the upright component. The body 4 is then urged towards the upright component 30 until the planar contact surface of the spacing elements 18 contact the front surface of the upright component 30. In this configuration, the arms 16 are able to snap back to their rest configuration and in so doing, the arms 16 secure the apparatus 2 to the upright component 30.

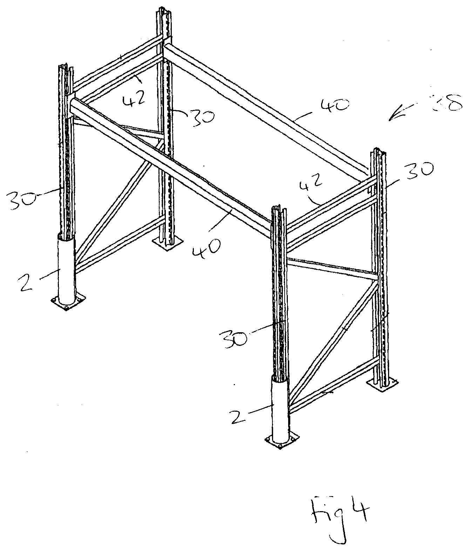

Figure 4 shows a storage racking assembly 38 according to the second aspect of the invention. As can be seen from Figure 4, the storage racking assembly comprises four upright components 30 arranged as the points of a rectangle. The opposed upright components 30 which define the longer sides of the rectangle are connected by first horizontal braces 40 and the opposed upright components 30 which define the shorter sides of the rectangle are connected by second horizontal braces 42. The opposed upright components 30 which define the shorter sides of the rectangle may include additional bracing components as shown in Figure 4. However, the bracing between the opposed upright components 30 which define the longer sides of the rectangle is limited owing to the need to access the storage area defined between the upright components 30.

The opposed upright components 30 which are located adjacent to an access aisle are each provided with a proximity sensing apparatus 2 as described above in connection with Figures 1, 2 and 3.

In use a mechanical handling apparatus approaches the racking assembly 38 along an access aisle (not shown) defined in front of the racking assembly 38. The proximity of the mechanical handling apparatus to the upright components 30 to which the proximity sensing apparatus 2 have been secured is sensed by the sensors 20. If the sensors 20 sense that the spacing between the respective upright component 30 and the mechanical handling apparatus is less than a predetermined spacing, the processor 10 transmits an activation signal to the audible signal emitter 12 and an alarm is emitted by the signal emitter 12. The alarm signal should alert the operator of the mechanical handling apparatus that he or she is too close to the racking assembly 38 and that remedial action needs to be taken to avoid a collision.

## Claims

1. A sensor apparatus (2) for connection to a storage rack (38), the sensor apparatus comprising a body (4) which defines a housing (6),
wherein the body is formed from a polymeric material and is resiliently deformable; a power source (8) located within the housing; one or more impact and/or
proximity sensors (20) located within the housing and electrically connected to the power
source; a processor (10) located within the housing and electrically connected to the power
source and the or each sensor; and a signal emitter (12) located within the housing and
electrically connected to the power source and the processor, wherein the signal emitter is configured to emit a signal in response to an activation signal from the processor; wherein the body has an arcuate cross-section; and wherein the body includes one or more attachment elements for securing the body to a storage rack; the or each attachment element is defined by the body, including one or more resiliently deformable anchor elements (16) extending from a main body portion of the body.

2. A sensor apparatus according to Claim 1, wherein the apparatus includes at least one impact sensor, the processor is configured such that the activation signal is transmitted by the processor in response to an impact sensed by the or one of the impact sensors and the emitted signal includes data relating to the force of the impact.

3. A sensor apparatus according to Claim 1 or Claim 2, wherein the sensor apparatus includes one or more impact sensors and one or more proximity sensors, wherein the sensors are electrically connected to the power source and the processor, and the signal emitter is further configured to emit an alert signal in response to a proximity activation signal from the processor.

4. A sensor apparatus according to Claim 1, wherein the sensor apparatus includes one or more proximity sensors, the processor is configured such that the activation signal is transmitted by the processor in response to an object in proximity to the apparatus sensed by the or one of the proximity sensors, and the signal emitter is configured to emit an alert signal in response to an activation signal from the processor.

5. A sensor apparatus according to Claim 3 or Claim 4, wherein the or each proximity sensor is configured to sense the proximity of a body to the apparatus within the range 0cm to 100cm.

6. A sensor apparatus according to Claim 5, wherein the or each proximity sensor is configured to sense the proximity of a body within a single pre-determined distance or within a plurality of pre-defined distances.

7. A sensor apparatus according to any of Claims 1 to 6, wherein the processor is configured to transmit the activation signal to the signal emitter when a body is sensed to be within a pre-determined distance from the sensor apparatus or when the impact sensors sense an impact with the housing.

8. A sensor apparatus according to Claim 7, wherein the signal emitter is configured to emit an audible alert signal, a visual alert signal, an electronic alert signal or combinations thereof.

9. A sensor apparatus according to any of Claims 1 to 8, wherein the power source comprises one or more batteries.

10. A sensor apparatus according to Claim 9, wherein the or each battery is rechargeable.

11. A sensor apparatus according to any of Claims 1 to 10, wherein the processor includes a data memory component which is configured to record data from the or each sensor.

12. A sensor apparatus according to any of Claims 1 to 11, wherein the arcuate cross-section defines an arc of between 60° and 270°.

13. A storage racking assembly including at least one upright component and a sensor apparatus as defined in any of Claims 1 to 12, wherein the sensor apparatus is secured to the upright component.

14. A storage racking assembly according to Claim 13, wherein the one or more resiliently deformable anchor elements are in the form of arms which extend from the main body portion of the body, wherein the resiliently deformable arms **are** configured to snap-fit around the upright component.

## Patentansprüche

1. Sensorvorrichtung (2) zur Verbindung mit einem Lagerregal (38), wobei die Sensorvorrichtung Folgendes umfasst: Einen Körper (4), der ein Gehäuse (6) definiert, wobei der Körper aus einem Polymermaterial geformt und elastisch verformbar ist; eine im Gehäuse befindliche Stromquelle (8); einen oder mehrere im Gehäuse befindliche und elektrisch mit der Stromquelle verbundene Aufprall- und/oder Näherungssensoren (20); einen im Gehäuse befindlichen und elektrisch mit der Stromquelle und dem oder jedem Sensor verbundenen Prozessor (10); und einen im Gehäuse befindlichen und elektrisch mit der Stromquelle und dem Prozessor verbundenen Signalemitter (12), wobei der Signalemitter dazu konfiguriert ist, als Reaktion auf ein Aktivierungssignal des Prozessors ein Signal zu emittieren; wobei der Körper einen bogenförmigen Querschnitt aufweist; und wobei der Körper ein oder mehrere Befestigungselemente zur Fixierung des Körpers an einem Lagerregal umfasst; wobei das oder jedes Befestigungselement durch den Körper definiert wird und ein oder mehrere elastisch verformbare Verankerungselemente (16) umfasst, die sich aus einem Hauptkörperabschnitt des Körpers erstrecken.

2. Sensorvorrichtung nach Anspruch 1, wobei die Vorrichtung mindestens einen Aufprallsensor umfasst, wobei der Prozessor derart konfiguriert ist, dass das Aktivierungssignal als Reaktion auf einen von dem oder einem der Aufprallsensoren erfassten Aufprall vom Prozessor gesendet wird, und das emittierte Signal Daten bezüglich der Stärke des Aufpralls umfasst.

3. Sensorvorrichtung nach Anspruch 1 oder Anspruch 2, wobei die Sensorvorrichtung einen oder mehrere Aufprallsensoren und einen oder mehrere Näherungssensoren umfasst, wobei die Sensoren elektrisch mit der Stromquelle und dem Prozessor verbunden sind und der Signalemitter ferner dazu konfiguriert ist, als Reaktion auf ein Näherungsaktivierungssignal des Prozessors, ein Warnsignal auszugeben.

4. Sensorvorrichtung nach Anspruch 1, wobei die Sensorvorrichtung einen oder mehrere Näherungssensoren umfasst, wobei der Prozessor derart konfiguriert ist, dass das Aktivierungssignal vom Prozessor als Reaktion auf ein Objekt in der Nähe der Vorrichtung, das von dem oder einem der Näherungssensoren erfasst wird, gesendet wird, und der Signalemitter dazu konfiguriert ist, als Reaktion auf ein Aktivierungssignal vom Prozessor, ein Warnsignal zu emittieren.

5. Sensorvorrichtung nach Anspruch 3 oder Anspruch 4, wobei der oder jeder Näherungssensor dazu konfiguriert ist, die Nähe eines Körpers zu der Vorrichtung innerhalb des Bereichs von 0 cm bis 100 cm zu erfassen.

6. Sensorvorrichtung nach Anspruch 5, wobei der oder jeder Näherungssensor dazu konfiguriert ist, die Nähe eines Körpers innerhalb eines einzigen vorbestimmten Abstands oder innerhalb einer Vielzahl von vordefinierten Abständen zu erfassen.

7. Sensorvorrichtung nach einem der Ansprüche 1 bis 6, wobei der Prozessor dazu konfiguriert ist, ein Aktivierungssignal an den Signalemitter zu senden, wenn erfasst wird, dass sich ein Körper innerhalb eines vorbestimmten Abstands von der Sensorvorrichtung befindet, oder wenn die Aufprallsensoren einen Aufprall auf das Gehäuse erfassen.

8. Sensorvorrichtung nach Anspruch 7, wobei der Signalemitter dazu konfiguriert ist, ein akustisches Warnsignal, ein optisches Warnsignal, ein elektronisches Warnsignal oder Kombinationen davon zu emittieren.

9. Sensorvorrichtung nach einem der Ansprüche 1 bis 8, wobei die Stromquelle eine oder mehrere Batterien umfasst.

10. Sensorvorrichtung nach Anspruch 9, wobei die oder jede Batterie wiederaufladbar ist.

11. Sensorvorrichtung nach einem der Ansprüche 1 bis 10, wobei der Prozessor eine Datenspeicherkomponente umfasst, die dazu konfiguriert ist, Daten von dem oder jedem Sensor aufzuzeichnen.

12. Sensorvorrichtung nach einem der Ansprüche 1 bis 11, wobei der bogenförmige Querschnitt einen Bogen zwischen 60° und 270° definiert.

13. Lagerregal-Baugruppe, die mindestens eine aufrechte Komponente und eine Sensorvorrichtung nach einem der Ansprüche 1 bis 12 umfasst, wobei die Sensorvorrichtung an der aufrechten Komponente befestigt ist.

14. Lagerregal-Baugruppe nach Anspruch 13, wobei das eine oder die mehreren elastisch verformbaren Ankerelemente als Arme ausgebildet sind, die sich aus dem Hauptkörperabschnitt des Körpers erstrecken, wobei die elastisch verformbaren Arme so konfiguriert sind, dass sie unter Einrasten um die aufrechte Komponente herumgreifen.

## Revendications

1. Appareil de détection (2) destiné à être connecté à une étagère de stockage (38), l'appareil de détection comprenant un corps (4) définissant un boîtier (6), dans lequel le corps est fabriqué à partir d'un matériau polymère tout en étant élastiquement déformable ; une source d'énergie (8) située à l'intérieur du boîtier ; un ou plusieurs capteurs d'impact et/ou de proximité (20) situés à l'intérieur du boîtier et connectés électriquement à la source d'énergie ; un processeur (10) situé à l'intérieur du boîtier et connecté électriquement à la source d'énergie et au capteur ou à chaque capteur ; et un émetteur de signaux (12) situé à l'intérieur du boîtier et connecté électriquement à la source d'énergie et au processeur, dans lequel l'émetteur de signaux est configuré pour émettre un signal en réponse à un signal d'activation provenant du processeur ; dans lequel le corps présente une section transversale en forme d'arc ; et dans lequel le corps comporte un ou plusieurs éléments de fixation permettant de fixer le corps à une étagère de stockage ; l'élément de fixation ou chaque élément de fixation est défini par le corps, y compris un ou plusieurs éléments d'ancrage élastiquement déformables (16) qui s'étendent à partir d'une partie principale du corps.

2. Appareil de détection selon la revendication 1, dans lequel l'appareil comprend au moins un capteur d'impact, le processeur est configuré de sorte que le processeur puisse transmettre le signal d'activation en réponse à un impact détecté par le capteur d'impact ou l'un des capteurs d'impact et le signal émis renferme des données sur la force de l'impact.

3. Appareil de détection selon soit la revendication 1, soit la revendication 2, dans lequel l'appareil de détection comprend un ou plusieurs capteurs d'impact et un ou plusieurs capteurs de proximité, dans lequel les capteurs sont connectés électriquement à la source d'énergie et au processeur, et l'émetteur de signaux est en outre configuré pour émettre un signal d'alerte en réponse à un signal d'activation de proximité provenant du processeur.

4. Appareil de détection selon la revendication 1, dans lequel l'appareil de détection comprend un ou plusieurs capteurs de proximité, le processeur est configuré de sorte que le processeur puisse transmettre le signal d'activation en réponse à la présence d'un objet à proximité de l'appareil que le capteur ou l'un des capteurs de proximité a détecté, et l'émetteur de signaux est configuré pour émettre un signal d'alerte en réponse à un signal d'activation provenant du processeur.

5. Appareil de détection selon soit la revendication 3, soit la revendication 4, dans lequel le capteur de proximité ou chaque capteur de proximité est configuré pour capter la présence d'un corps à proximité de l'appareil dans un rayon de 0 cm à 100 cm.

6. Appareil de détection selon la revendication 5, dans lequel le capteur de proximité ou chaque capteur de proximité est configuré pour détecter la proximité d'un corps dans le rayon d'une seule distance prédéterminée ou d'une pluralité de distances prédéterminées.

7. Appareil de détection selon l'une quelconque des revendications 1 à 6, dans lequel le processeur est configuré pour transmettre le signal d'activation à l'émetteur de signaux lors de la détection d'un corps dans le rayon d'une distance prédéterminée de l'appareil de détection ou lorsque les capteurs d'impact détectent un impact à l'intérieur du boîtier.

8. Appareil de détection selon la revendication 7, dans lequel l'émetteur de signaux est configuré de sorte à émettre un signal d'alerte audible, un signal d'alerte visuel, un signal d'alerte électronique ou des combinaisons de ceux-ci.

9. Appareil de détection selon l'une quelconque des revendications 1 à 8, dans lequel la source d'énergie est dotée d'une ou de plusieurs batteries.

10. Appareil de détection selon la revendication 9, dans lequel la batterie ou chaque batterie est rechargeable.

11. Appareil de détection selon l'une quelconque des revendications 1 à 10, dans lequel le processeur est doté d'un composant de mémoire de données qui est configuré pour enregistrer des données provenant du capteur ou de chaque capteur.

12. Appareil de détection selon l'une quelconque des revendications 1 à 11, dans lequel la section transversale en forme d'arc définit un arc compris entre 60° et 270°.

13. Ensemble d'étagère de stockage comportant au moins un élément vertical et un appareil de détection, selon l'une quelconque des revendications 1 à 12, dans lequel l'appareil de détection est fixé sur l'élément vertical.

14. Ensemble d'étagère de stockage selon la revendication 13, dans lequel l'élément ou plusieurs éléments d'ancrage élastiquement déformables se présentent sous la forme de bras qui partent de la partie principale du corps, dans lequel les bras élastiquement déformables sont configurés pour s'enclencher autour de l'élément vertical.
